# EUROPEAN PATENT SPECIFICATION

(11) **EP 1 179 886 B1**
(45) Date of publication and mention of the grant of the patent: **27.09.2006**
(21) Application number: 01115175.0
(22) Date of filing: 22.06.2001
(51) Int. Cl.: H03B 5/06

(54) **Oscillator and method of controlling it**
Oszillator und Steuerverfahren dafür
Oscillateur et méthode de son controle

(30) Priority: 31.07.2000 JP 2000231675
(43) Date of publication of application: 13.02.2002
(73) Proprietor: SEIKO EPSON CORPORATION, Shinjuku-ku, Tokyo 163-0811 (JP)
(72) Inventor: Kobayashi, Yoshihiro, c/o Seiko Epson Corp., Suwa-shi, Nagano-ken 392-8502 (JP); Endo, Takashi, c/o Seiko Epson Corp., Suwa-shi, Nagano-ken 392-8502 (JP)
(74) Representative: Hoffmann, Eckart

(56) References cited:
- EP-A- 0 987 822
- US-A- 4 307 354

## Description

The present invention relates to an oscillator for controlling the oscillator, and more particularly, to an oscillator for use in electronic equipment such as a power-saving mobile telephone.

Since electronic equipment uses a low power source voltage and a low drive voltage of circuits for power saving, an oscillator used in such electronic equipment is driven at a voltage lower than that in conventional equipment.

As the voltage for driving an oscillator is lowered, however, the oscillator is more subject to the operation environment, such as noise, power source fluctuations, temperature changes, and vibration, and variations in characteristics of components. The oscillator remains unable to start oscillating with the oscillation amplitude not growing at the start of oscillation or remains unstable in the oscillation state thereof, although the probability of such troubles is very low. In such a case, an electronic equipment having the oscillator may not normally operate.

Particularly in electronic equipment, such as a mobile telephone which intermittently repeats receiving operations for power saving, the oscillator is frequently started, and the probability of aborted oscillation becomes high. It is thus preferred to take measures for preventing such problems in the oscillator.

US-4,307,354 discloses an oscillator circuit in which the operating point of the transistors of an inverter is changed to facilitate start of oscillation when the oscillator circuit is not oscillating or the oscillation is unstable. A frequency divider is connected to the output of the oscillator circuit and drives a waveform detector to detect whether or not the oscillator circuit is oscillating. If not two switches are controlled to apply additional bias voltage to the two transistors of the inverter.

An oscillator according to the pre-characterizing portion of claim 1 is known from EP-A-0 987 822. In this prior art the oscillator is a voltage-controlled oscillator (VCO) of a PLL circuit for generating an oscillation signal synchronized with a reference clock signal. When the VCO stops oscillating an oscillation monitoring circuit driven by the reference clock signal applies a pulse shaped monitoring signal to an oscillation control circuit. The latter applies a pulse shaped oscillation control signal to switches in the VCO to temporarily bring the VCO in a disabled state and induce oscillation restart thereafter.

The object of the present invention is to provide an oscillator which reliably oscillates even when the oscillator is driven at a low voltage.

This object is achieved with an oscillator as claimed in claim 1. Preferred embodiments of the invention are subject-matter of the dependent claims.

The present invention causes an oscillator to reliably oscillate when the oscillator is driven at a low voltage.

This and other objects and features of the present invention will be readily understood from the following detailed description of preferred embodiments taken in conjunction with the accompanying drawings, in which like parts are designated by like reference numerals and in which:
- FIG. 1: is a block diagram schematically showing the basic construction of an oscillator of the present invention;
- FIG. 2: is a block diagram showing the construction of an oscillator of a first embodiment of the present invention;
- FIG. 3: is a timing chart for the oscillator in Fig. 2;
- FIG. 4: is a block diagram showing the construction of an oscillator of a second embodiment of the present invention;
- FIG. 5: is a timing chart for the oscillator of Fig. 4;
- FIG. 6: is a block diagram showing a first modification of the embodiments of the present invention;
- FIG. 7: is a block diagram showing a second modification of the embodiments of the present invention; and
- FIG. 8: is a timing chart of the oscillator.

### (1) Embodiments

### (1.1) Summary of the Embodiments

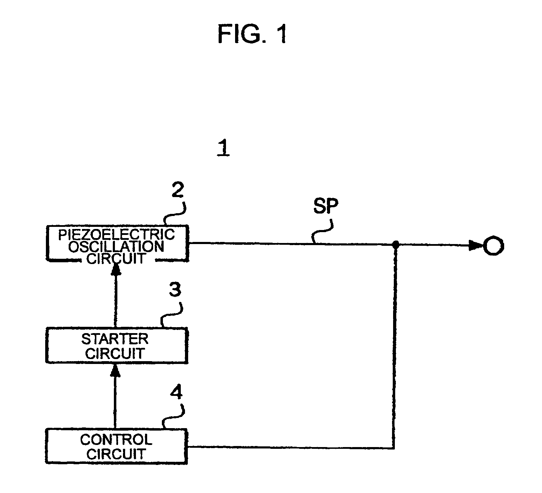

FIG. 1 is a block diagram schematically showing the basic construction of an oscillator of the present invention. The oscillator 1 includes a piezoelectric oscillation circuit 2, a starter circuit 3 for repeatedly starting the oscillation circuit 2, and a control circuit 4 for controlling the starter circuit 3.

When power for the oscillator 1 is switched on or when a standby state is canceled, the starter circuit 3 feeds power to the oscillation circuit 2 to cause it to start oscillating.

In this case, the starter circuit 3 intermittently feeds power to the oscillation circuit 2 until the control circuit 4 detects a pulse signal SP output by the oscillation circuit 2. The oscillation circuit 2 thus repeats start and stop of oscillation.

When the control circuit 4 detects the pulse signal SP output by the oscillation circuit 2, the starter circuit 3 keeps the oscillation circuit 2 in a driven state.

Specifically, when the oscillation circuit 2 fails to start oscillating, the startup operation for the oscillation circuit 2 is repeated so that the state for facilitating the start of the oscillation circuit 2 develops, i.e., a number of opportunities of transient response allowing the oscillation amplitude of the oscillation circuit 2 to grow are created to cause the oscillation circuit 2 to reliably oscillate.

The oscillator 1 thus reliably operates even when the oscillation circuit 2 has difficulty in oscillating under the influence of factors, such as noise, power source fluctuations, temperature changes, vibration, and variations in component characteristics.

The oscillator 1 not only causes the oscillation circuit 2 to reliably oscillate at the startup as described above, but also causes the control circuit 4 to continuously monitor the pulse signal SP output from the oscillation circuit 2 to detect an interruption of the oscillation, if any. When the oscillation is interrupted, a state under which the oscillation circuit 2 easily oscillates is created so that the oscillation state is reliably restored.

Preferred embodiments of the oscillator are now discussed in more detail.

### (1.2) First embodiment

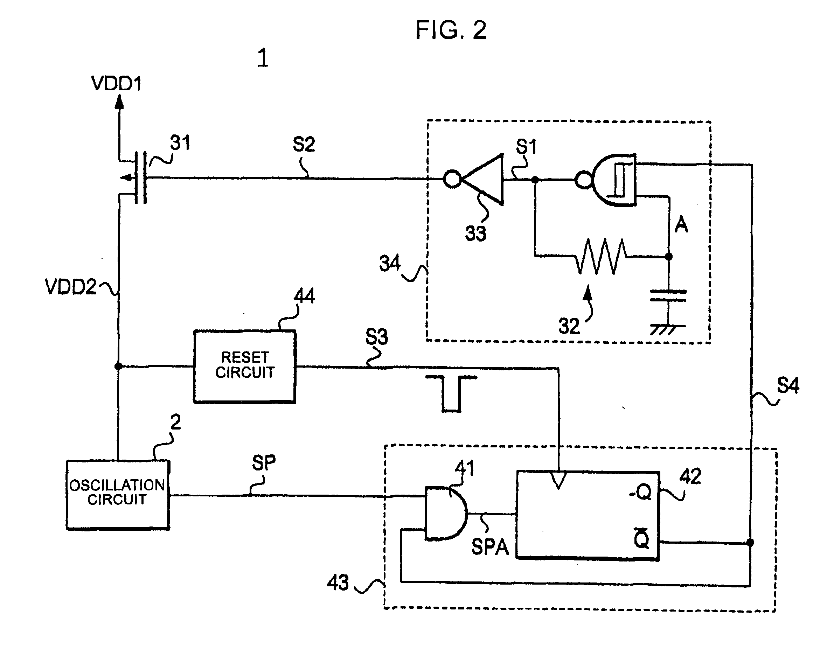

FIG. 2 is a block diagram showing the construction of an oscillator of a first embodiment of the present invention.

In this oscillator 10, the starter circuit 3 includes a switch (a P-channel FET) 31 in a power supply line of the oscillation circuit 2, and a start drive circuit 34 composed of a Schmitt trigger oscillation circuit 32 (simply called "ST circuit" hereinafter) and an inverter 33.

The control circuit 4 includes an oscillation start detector circuit 43 composed of an AND circuit 41 and a counter 42, and a reset circuit 44 which resets the counter 42 when the oscillation circuit 2 is supplied with a power source voltage VDD2. The counter 42 drives an inverted output terminal /Q thereof from high to low at the moment the count of the counter 42 reaches a predetermined value.

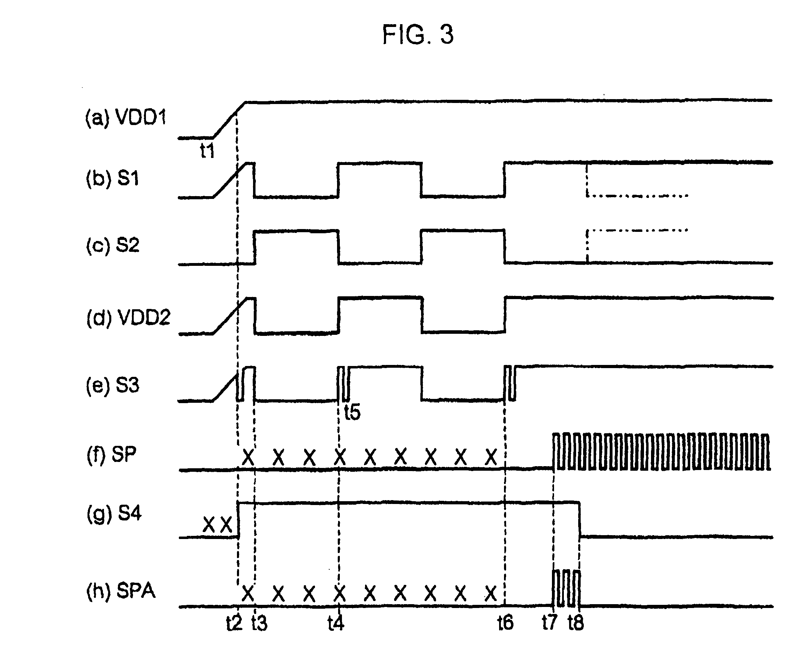

The operation of the oscillator 10 is now discussed, with reference to a timing chart shown in FIG. 3.

Referring to FIG. 3(a), when the power source voltage VDD1 is supplied to the oscillator 10 at time t1, the ST circuit 32 is at a low level at point A in FIG. 2. Referring to FIG. 3(b), the output signal S1 of the ST circuit 32 is driven high, and the start drive circuit 34 outputs a low-level switch control signal S2 as shown in FIG. 3(c).

When the oscillator 10 is supplied with the power source voltage VDD1, the switch control signal S2, thus, turns on the switch 31, and a power source voltage VDD2 is fed to the oscillation circuit 2 to start it as shown in FIG. 3(d).

When the switch 31 is turned on, the reset circuit 44 outputs a reset signal S3 at time t2 as shown in FIG. 3(e), thereby resetting the counter 42 of the oscillation start detector circuit 43 as shown in FIG. 3(g) and driving high the output level S4 at the inverted output terminal /Q.

In this way, the ST circuit 32 of the start drive circuit 34 starts oscillating, and one of the input terminals of the AND circuit 41 of the oscillation start detector circuit 43 is driven high. When the oscillation circuit 2 outputs the pulse signal SP, the counter 42 counts pulses of the pulse signal SP, starting from zero.

When the oscillation circuit 2 fails to start oscillating for any reason, or when oscillation circuit 2 fails to start oscillating immediately subsequent to the supply of the power source voltage VDD2 because of an unstable operation thereof as shown in FIG. 3(f), the output signal S1 of the ST circuit 32 is driven low before the count of the counter 42 reaches a predetermined value as shown in FIG. 3(b) (time t3). The letters "X" shown in FIG. 3 represent that no pulse signal SP is output.

As a result, as shown in FIG. 3(c), the switch control signal S2 is assumes a high level at time t3. The switch 31 is turned off, thereby cutting off the supply of the power source voltage VDD2 to the oscillation circuit 2 to stop the start of the oscillation circuit 2 (FIG. 3(d)).

Specifically, when the count of the counter 42 fails to reach the predetermined value within a certain time while the oscillation circuit 2 is driven, the supply of the power source voltage VDD2 to the oscillation circuit 2 is suspended to stop the driving of the oscillation circuit 2 based on the determination that the oscillation circuit 2 is not oscillating.

Since the output level S4 at the inverted output terminal /Q of the counter 42 is maintained high as shown in FIG. 3(g), the oscillation of the ST circuit 32 continues, the output signal S1 is changes to high again (FIG. 3(b)) at time t4, and the switch control signal S2 is assumes low (FIG. 3(c)).

In this way, the switch 31 is turned on when half the oscillation period of the ST circuit 32 has elapsed subsequent to the turn off of the switch 31, To restart the oscillation circuit 2, the power source voltage VDD2 is fed to the oscillation circuit 2 (FIG. 3(d)).

As shown in FIG. 3(e), the reset signal S3 is output by the reset circuit 44 at time t5, thereby resetting the counter 42 of the oscillation start detector circuit 43. Consequently, when the oscillation circuit 2 outputs the pulse signal SP, the counter 42 starts counting the pulse signal SP from zero.

In this way, in the oscillator 10, the oscillation circuit 2 is started depending on the output signal S1 of the ST circuit 32. If the count of pulses of the pulse signal SP output from the oscillation circuit 2 fails to reach the predetermined value by the time the level of the output signal S1 is inverted (within half the oscillation period of the ST circuit 34) subsequent to the startup of the oscillation circuit 2, the start of the oscillation circuit 2 is suspended. When the level of the output signal S1 is inverted again, the start-up operation of the oscillation circuit 2 is repeated again.

Specifically, when the count fails to reach the predetermined value because of a failure of the oscillation circuit 2 to operate normally, the startup and the suspension of the startup of the oscillation circuit 2 are repeated with half the oscillation period of the ST circuit 32 to prompt oscillation.

In this way, until the oscillation circuit 2 oscillates normally, the oscillator 10 creates the state in which the oscillation circuit 2 easily starts oscillating, namely, a number of opportunities of transient response allowing the oscillation amplitude of the oscillation circuit 2 to grow. The oscillator 10 is thus reliably operated even when driven at a low voltage.

After the oscillator 10 restarts the oscillation circuit 2 at time t6, the oscillation circuit 2 starts operating normally at time t7. When the counter 42 counts the pulses of the pulse signal SP of the oscillation circuit 2 and reaches the predetermined value (at time t8), the output signal S4 of the inverted output terminal /Q of the counter 42 turns to a low level (FIG. 3(g)), and the ST circuit 32 stops oscillating, thereby maintaining the connection state of the switch 31 in the on state.

As a result, the power source voltage VDD2 is continuously fed to the oscillation circuit 2, keeping the oscillation circuit 2 in a driven state. The oscillation circuit 2 thus continuously outputs the pulse signal SP.

### (1.3) Second embodiment

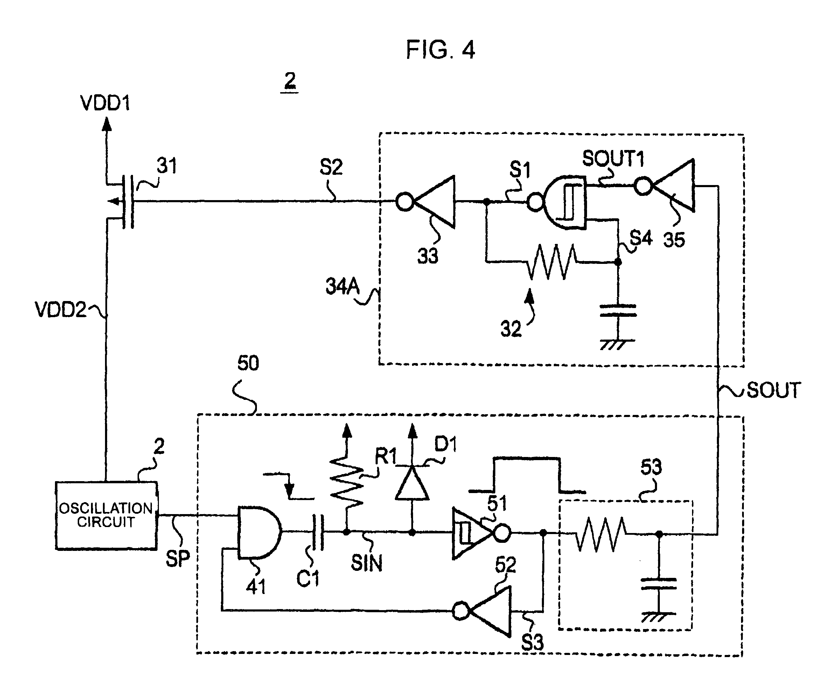

FIG. 4 is a block diagram showing the construction of an oscillator of a second embodiment of the present invention.

Oscillator 20 of this second embodiment differs from that of the first embodiment in the arrangement in the control circuit 4 and in that an inverter 35 is added to the signal input side of the start drive circuit denoted 34A.

In the oscillator 20, the control circuit 4 comprises an oscillation stop detector circuit 50 including a capacitor C1, a pull-up resistor R1, and a diode D1 between an AND circuit 41 and a Schmitt inverter 51. The output signal S3 of the Schmitt inverter 51 is fed to one of the input terminals of the AND circuit 41 through an inverter 52. The detector circuit 50 further includes a CR integrator circuit 53 for integrating the output signal S3 of the Schmitt inverter 51.

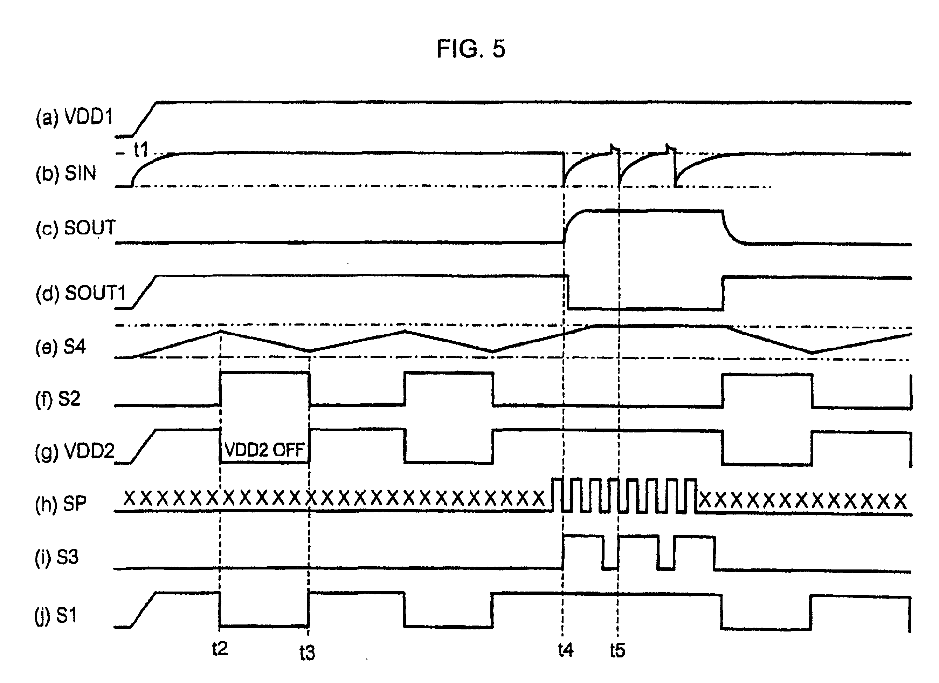

The operation of the second embodiment of oscillator 20 is now discussed with reference to a timing chart shown in FIG. 5.

When a power source voltage VDD1 is supplied at time t1 to the oscillator 1 as shown in FIG. 5(a), the output signal S1 of the ST circuit 32 turns to a high level (FIG. 5(a)) in the same manner as in the first embodiment, the start drive circuit 34A outputs a low-level switch control signal S2 (FIG. 5(f)), the switch 31 is turned on, and the power source voltage VDD2 is fed to the oscillation circuit 2 to start the oscillation circuit 2 (FIG. 5(g)).

As shown in FIG. 5(b), in the oscillation stop detector circuit 50, an input signal SIN of the Schmitt inverter 51 is pulled up to a high level through the pull-up resistor R1, and a low-level output signal SOUT is fed to the inverter 35 of the start drive circuit 34A through the CR integrator circuit 53, as shown in FIG. 5(c). In this way, the ST circuit 32 starts oscillating.

When a feedback signal S4 of the ST circuit 32 exceeds a predetermined level at time t2 as shown in FIG. 5(g) in the event of an aborted oscillation of the oscillation circuit 2, it is judged to have be substantially high level and the start drive circuit 34A outputs a high-level switch control signal S2 as shown in FIG. 5(f). The switch 31 is turned off, thereby cutting off the supply of the power source voltage VDD2 to the oscillation circuit 2 (FIG. 5(g)).

At the moment the output signal S1 of the ST circuit 32 is assumes high level as shown in FIG. 5(j) at time t3, the start drive circuit 34A outputs a low-level switch control signal S2 as shown in FIG. 5(f). The switch 31 is then turned on, thereby feeding the power source voltage VDD2 to the oscillation circuit 2 to start the oscillation circuit 2 (FIG. 5(g)).

Referring to FIG. 5(h), the oscillation circuit 2 in the oscillator 20 starts oscillating normally at time t4 (time t5), outputting the pulse signal SP. The input signal SIN to the Schmitt inverter 51 is assumes low level in response to the falling edge of the pulse signal SP. Referring to FIG. 5(b), a one-shot pulse having a time constant determined by the capacitor C1 and the pull-up resistor R1 is input to the Schmitt inverter 51.

In this case, the inverted version of the one-shot pulse is smoothed (integrated) by the CR integrator circuit 53, and the high-level output signal SOUT is then fed to the start drive circuit 34A.

While the one-shot pulse is output, the ST circuit 32 stops oscillating, thereby keeping the switch 31 in an on state. In this way, the power source voltage VDD is continuously fed to the oscillation circuit 2 to allow the oscillation circuit 2 to continuously output the pulse signal SP.

In this way, until the oscillation circuit 2 outputs the pulse signal SP, the oscillator 20 repeats the startup control and the suspension control of startup of the oscillation circuit 2 based on the output signal S1 of the ST circuit 32. Like the first embodiment, the second embodiment creates the state in which the oscillation circuit 2 easily starts oscillating, namely, a number of opportunities of transient response allowing the oscillation amplitude of the oscillation circuit 2 to grow. The oscillator 20 operates reliably even when driven at a low voltage.

The oscillator 20 maintains the connection state of the switch 31 in an on state only while the one-shot pulses are output based on the pulse signal SP of the oscillation circuit 2. Therefore, the oscillation circuit 2 is quickly and reliably oscillated even when the oscillation of the pulse signal SP is followed by an interruption of the oscillation.

### (2) Modifications

### (2.1) First modification

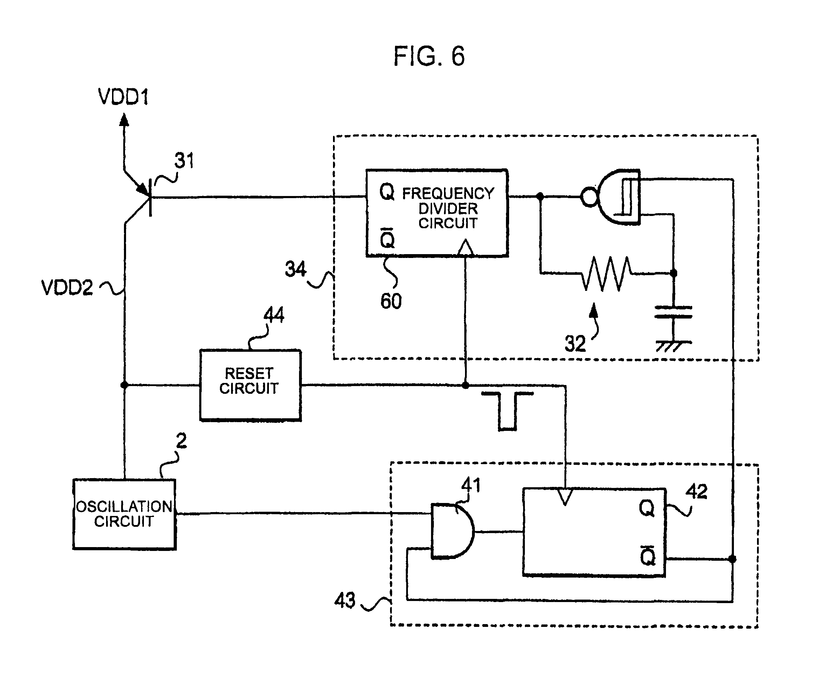

In the preceding embodiments, the interval within which the startup of the oscillation circuit is repeated depends on the oscillation period of the ST circuit 32. As shown in FIG. 6, the interval of repeated startup of the oscillation circuit 2 may be easily set to be a desired time interval by arranging a frequency divider circuit 60 in succession to the ST circuit 32.

The preceding embodiments have been discussed in conjunction with the use of MOS transistor switch 31. Alternatively, widely available switching elements, such as a bipolar transistor shown in FIG. 6, may be employed instead. Note that MOS transistor switch 31 may be replaced by another type of switch irrespective of whether or nor frequency divider 60 is employed.

### (2.2) Second modification

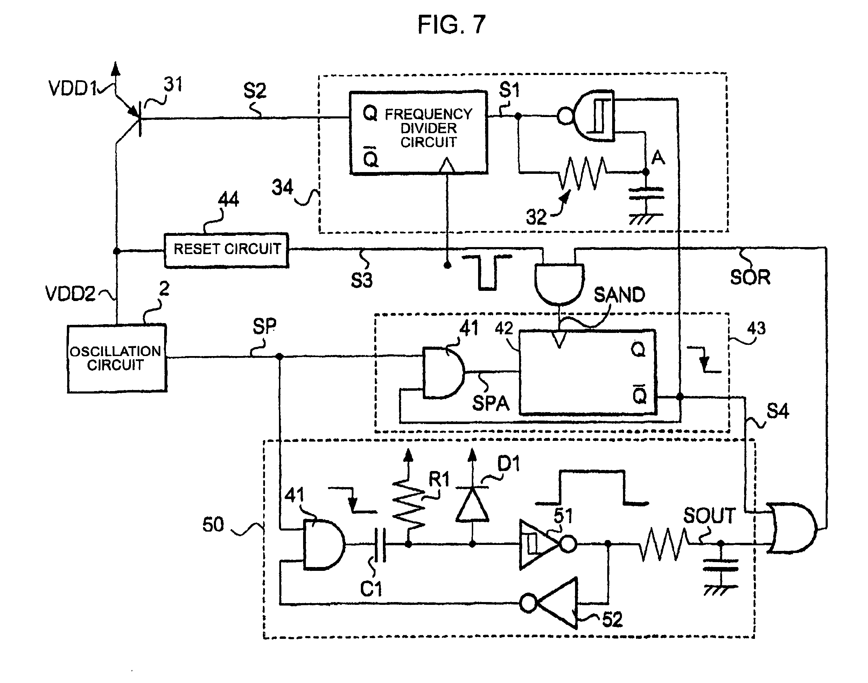

In the above discussion of the first embodiment, the reset circuit 44 for resetting the counter 42 is used to control the startup of the oscillation circuit 2. As shown in FIG. 7, a second modification of the present invention includes the oscillation stop detector circuit 50 of the oscillator 20 of the second embodiment added to the oscillator 10 of the first embodiment. The second modification thus resets counter 42 by an ANDed signal SAND of the reset signal S3 and an ORed signal SOR which is obtained by ORing the output signal SOUT of the oscillation stop detector circuit 50 and the output signal S4 of the oscillation start detector circuit 43. The oscillation circuit 2 is thus started again not only at the power on but also when the oscillation is followed by a subsequent interruption.

In addition to the operation of the oscillator 10 of the first embodiment for reliably starting oscillation, the oscillator of the second modification performs the operation of the oscillator 20 of the second embodiment in which the oscillator is oscillated in the event that once started oscillation is interrupted.

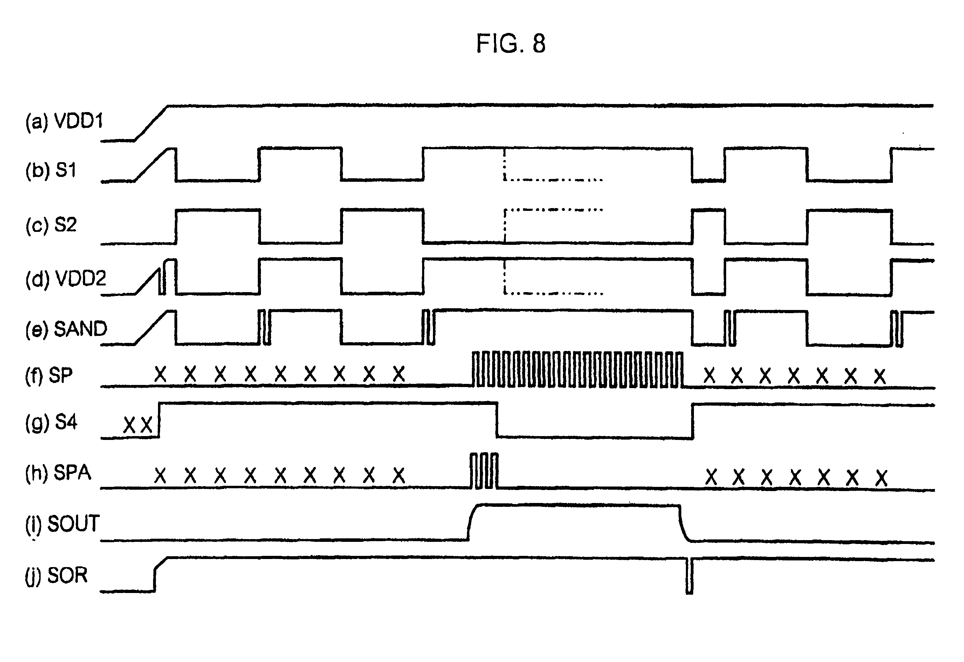

FIG. 8 shows a timing chart showing the operation of the oscillator according to this second modification. Since the oscillator combines the operation of the oscillator 10 of the first embodiment and the operation of the oscillator 20 of the second embodiment as already discussed, this timing chart will be understood by reference to the discussion of the preceding embodiments.

### (2.3) Third modification

In the preceding embodiments, the oscillation circuit 2 is repeatedly subjected to startup control only when no oscillation state occurs, or when the oscillation circuit 2 fails to oscillate in a reliable fashion. The present invention is not limited to these cases, however. For example, when the oscillation circuit happens to oscillate in a third-order vibration mode rather than in a first-order vibration mode which is originally intended, the oscillation circuit 2 should be repeatedly subjected to startup control to revert back to the normal oscillation state.

To cope with this problem, a method in accordance with the first embodiment may be used to restart the oscillation circuit 2 into oscillation when the count of the counter 42 fails to reach the predetermined value or is out of a predetermined range. Also a method in accordance with the first embodiment may be used to restart the oscillation circuit 2 into oscillation when the frequency of the pulse signal SP of the oscillation circuit 2 is frequency-voltage converted and the converted voltage falls outside a predetermined voltage range.

## Claims

1. An oscillator comprising:
oscillation means (2);
drive means (3) for prompting the oscillation means (2) to start oscillating by repeatedly performing drive control and drive stop control to the oscillation means (2); and
control means (4) for controlling the drive means (3) to prompt the oscillation means (2) to oscillate when the oscillation means (2) is not oscillating, and for maintaining the oscillation means (2) in a driven state when the oscillation means (2) is oscillating
**characterized in that**
said drive means comprises a trigger oscillator circuit (32); and
said control means (4) is adapted to control the drive means so as to cause oscillation of the trigger oscillator circuit (32) in order to prompt the oscillation means to oscillate and to control the drive means so as to cause a stop of the oscillation of the trigger oscillator circuit (32) so as to maintain the oscillation means (2) in said driven state.

2. An oscillator according to claim 1, wherein the control means (4) has a counter (42) for counting pulses of a pulse signal output from the oscillation means (2) when the oscillation means (2) is oscillating and is adapted to determine that the oscillation means (2) is not oscillating when the count value of the counter fails to reach a predetermined value during drive control of the oscillation means (2), and to determine that the oscillation means (2) is oscillating when the count value reaches the predetermined value.

3. An oscillator according to claim 1, wherein the control means (4) is adapted to control the drive means (3) to cause oscillation of the trigger oscillator circuit (32) when no pulse signal output from the oscillation means (2) is detected, and to control the drive means (3) to stop oscillation of the trigger oscillator circuit (32) for a predetermined duration of time each time the pulse signal is detected.

4. An oscillator according to one of claims 1 through 3, wherein the drive means (3) comprises:
switching means (31) arranged in one of power supply lines to the oscillation means (2); and
switch control means (34) for controlling the switching means (31) for on/off control with a period longer than the period of the pulse signal of the oscillation means (2).

## Patentansprüche

1. Oszillator mit:
einem Schwingmittel (2);
einem Treibermittel (3) zum Veranlassen des Schwingmittels (2) zum Anschwingen durch wiederholtes Durchführen einer Antriebssteuerung und Antriebsstoppsteuerung an dem Schwingmittel (2); und
einem Steuermittel (4) zum Steuern des Treibermittels (3), um das Schwingmittel (2) zum Schwingen zu veranlassen, wenn das Schwingmittel (2) nicht schwingt, und um das Schwingmittel (2) in einem angetriebenen Zustand zu halten, wenn das Schwingmittel (2) schwingt,
**dadurch gekennzeichnet, dass**
das Treibermittel eine Trigger-Oszillatorschaltung (32) umfasst; und
das Steuermittel (4) eingerichtet ist, das Treibermittel zu steuern, um eine Schwingung der Trigger-Oszillatorschaltung (32) zu bewirken, um das Schwingmittel zum Schwingen zu veranlassen, und das Treibermittel zu steuern, um einen Stopp der Schwingung der Trigger-Oszillatorschaltung (32) zu bewirken, um das Schwingmittel (2) in dem angetriebenen Zustand zu halten.

2. Oszillator nach Anspruch 1, bei dem das Steuermittel (4) einen Zähler (42) zum Zählen von Impulsen eines Impulssignals hat, das von dem Schwingmittel (2) ausgegeben wird, wenn das Schwingmittel (2) schwingt, und eingerichtet ist, um festzustellen, dass das Schwingmittel (2) nicht schwingt, wenn der Zählwert des Zählers während der Antriebssteuerung des Schwingmittels (2) einen vorgegebenen Wert nicht erreicht, und festzustellen, dass das Schwingmittel (2) schwingt, wenn der Zählwert den vorgegebenen Wert erreicht.

3. Oszillator nach Anspruch 1, bei dem das Steuermittel (4) eingerichtet ist, das Treibermittel (3) zu steuern, um eine Schwingung der Trigger-Oszillatorschaltung (32) zu bewirken, wenn kein von dem Schwingmittel (2) ausgegebenes Impulssignal erfasst wird, und das Treibermittel (3) zu steuern, um die Schwingung der Trigger-Oszillatorschaltung (32) jedes Mal, wenn das Impulssignal erfasst wird, für eine vorgegebene Zeit zu stoppen.

4. Oszillator nach einem der Ansprüche 1 bis 3, bei dem das Treibermittel (3) umfasst:
ein in einer von Stromversorgungsleitungen zum Schwingmittel (2) angeordnetes Schaltmittel (31) und
ein Schaltersteuermittel (34) zum Steuern des Schaltmittels (31) für Ein/Aus-Steuerung mit einer Periode, die länger als die Periode des Impulssignals des Schwingmittels (2) ist.

## Revendications

1. Oscillateur comprenant :
des moyens (2) d'oscillation;
des moyens (3) d'attaque pour inciter les moyens (2) d'oscillation à commencer à osciller en effectuant de manière répétée une commande d'attaque et une commande d'arrêt d'attaque des moyens(2) d'oscillation ; et
des moyens (4) de commande des moyens (3) d'attaque pour inciter les moyens (2) d'oscillation à osciller lorsque les moyens (2) d'oscillation n'oscillent pas et pour maintenir les moyens (2) d'oscillation dans un état attaqué lorsque les moyens (2) d'oscillation oscillent,
**caractérisé en ce que**
les moyens d'attaque comprennent un circuit (32) oscillant de déclenchement ; et
les moyens (4) de commande sont conçus pour commander les moyens d'attaque de manière à provoquer une oscillation du circuit (32) oscillant de déclenchement afin d'inciter les moyens d'oscillation à osciller et afin de commander les moyens d'attaque de manière à provoquer un arrêt de l'oscillation du circuit (32) oscillant d'attaque de manière à maintenir les moyens (2) d'oscillation dans l'état attaqué.

2. Oscillateur suivant la revendication 1, dans lequel les moyens (4) de commande ont un compteur (42) pour compter des impulsions d'un signal d'impulsion sortant des moyens (2) d'oscillation lorsque les moyens (2) d'oscillation oscillent et est conçu pour déterminer que les moyens (2) d'oscillation n'oscillent pas lorsque la valeur de compte du compteur n'atteint pas une valeur déterminée à l'avance pendant une commande d'attaque des moyens (2) d'oscillation et pour déterminer que les moyens (2) d'oscillation oscillent lorsque la valeur du compte atteint la valeur déterminée à l'avance.

3. Oscillateur suivant la revendication 1, dans lequel les moyens (4) de commande sont conçus pour commander les moyens (3) d'attaque pour provoquer l'oscillation du circuit (32) oscillant de déclenchement lorsqu'il n'est pas détecté la sortie d'un signal d'impulsion des moyens (2) d'oscillation et pour commander les moyens (3) d'attaque afin d'arrêter l'oscillation du circuit (32) oscillant de déclenchement pendant une durée déterminée à l'avance chaque fois que le signal d'impulsion est détecté.

4. Oscillateur suivant l'une des revendications 1 à 3, dans lequel les moyens (3) d'attaque comprennent
des moyens (31) de commutation montés dans l'une des lignes d'alimentation en courant des moyens (2) d'oscillation; et
des moyens (34) de commande des moyens (31) de commutation pour une commande marche/arrêt d'une durée plus longue que la durée du signal d'impulsion des moyens (2) d'oscillation.
